# EUROPEAN PATENT SPECIFICATION

(11) **EP 4 243 070 B1**
(45) Date of publication and mention of the grant of the patent: **21.05.2025**
(21) Application number: 22161568.5
(22) Date of filing: 11.03.2022
(51) Int. Cl.: H01L 25/07, H01L 23/64, H01L 23/498, H01L 23/00, H02M 7/00

(54) **POWER MODULE AND METHOD FOR MANUFACTURING A POWER MODULE**
LEISTUNGSMODUL UND VERFAHREN ZUM HERSTELLEN EINES LEISTUNGSMODULS
MODULE DE PUISSANCE ET PROCÉDÉ DE FABRICATION D'UN MODULE DE PUISSANCE

(43) Date of publication of application: 13.09.2023
(73) Proprietor: Hitachi Energy Ltd, 8050 Zürich (CH)
(72) Inventor: FISCHER, Fabian, 5400 Baden (CH); ROESCH, Andreas, 79730 Murg (DE); PAQUES, Gontran, 5600 Lenzburg (CH)
(74) Representative: Epping - Hermann - Fischer

(56) References cited:
- DE-A1- 102004 025 609
- US-A1- 2012 256 194
- US-A1- 2013 001 805
- US-A1- 2020 266 240

## Description

The present disclosure relates to a power module and a method for manufacturing a power module. The power module can be used in power electronic applications, such as motor drives or power converters in electric vehicles (EV), for example.

The power module is a half-bridge power module comprising two groups of power semiconductor devices, wherein one group comprises one or more high-side devices and the other group comprises one or more low-side devices. Both groups of power semiconductor devices can be monitored and controlled independently, so that two individual monitoring or control circuits are available for high-side and low-side devices. The control circuit may comprise a gate connection and an auxiliary emitter or source connection, for example.

WO 2020008874 and WO 2020158057 A1 disclose a power module in half-bridge configuration. CN 110867419 A discloses a power module in full-bridge configuration. US 20190115275 A1 discloses a further example of a power module.

US 2012/256194 A1 discloses a power module in half-bridge configuration, wherein high-side and low-side terminals have mirror-symmetric shapes.

DE 10 2004 025609 A1 discloses a half-bridge power module, wherein auxiliary terminals are formed as contact springs for providing a connection between conductor paths of a substrate and conductor paths of a printed circuit board. US 2013/001805 A1 discloses a half-bridge power module where common gate control terminals and common emitter control terminals are provided for two units of insulating boards, wherein the terminals are connected by bond wires to wiring patterns.

US 2014/231982 A1 discloses a power module with auxiliary electrode terminals being connected to metallization patterns of different shapes.

US 2020/266240 A1 discloses a semiconductor module having semiconductor switching elements, wherein an induced electromotive force is generated at a gate control wire or an emitter wire, so as to reduce a difference in gate-emitter voltage based on a parasitic inductance between the two semiconductor switching elements.

Embodiments of the disclosure relate to an improved power module. At least some of the embodiments may have an improved switching behavior.

According to a first aspect of the invention, a half-bridge power module according to claim 1 is proposed.

In the following, also mirror-symmetric shapes for the auxiliary terminals and the metallization patterns are disclosed. The invention, however, is defined as in the independent claims with the high-side auxiliary terminal and the low-side auxiliary terminal having the same geometric shapes.

The auxiliary terminals can be in the form of metal sheets, for example. Each of the auxiliary terminals may be formed from a single piece.

When the intermediate portion comprises at least one horizontal section running horizontally, said at least one horizontal section runs only in a horizontal direction at a constant height. The horizontal section may be bar-shaped, for example.

In embodiments which do not form part of the claimed invention, it is also possible that the internal connection portion is located at a different vertical position but at the same horizontal position as the external connection portion. In this case, the auxiliary terminal may comprise a U-shaped intermediate portion, for example.

Thus, the auxiliary terminal has a three-dimensional structure and is not in the form of a simple pin-shaped terminal which merely extends upwards from the substrate.

As examples, an auxiliary terminal may be a component in an auxiliary electrical circuit such as a signal path for connecting external connectors to a gate of the switching device. As a further example, the auxiliary electrical circuit may be an auxiliary connection to an emitter or source of the switching device. In embodiments, the auxiliary terminals with the same geometric shapes are corresponding terminals. "Corresponding" terminals have the same functionality for the high-side switching device and the low-side switching device. As an example, the auxiliary terminals connected to gates of the switching devices are corresponding terminals. The auxiliary terminals connected to emitters of the switching devices are corresponding terminals.

The switching device may be in the form of an IGBT, a MOSFET, a HEMT, a JFET or a MISFET, for example. The power module may comprise several high-side and several low-side switching devices, wherein the switching devices of the same side may be electrically connected in parallel to each other.

By using auxiliary terminals of the same shape in corresponding electrical paths for the high-side and low-side switching devices, the parasitic inductance in these paths are adjusted to each other so that the homogeneity of the switching behavior of the high-side and low-side devices is improved or in the best case, an identical switching behavior can be achieved. Furthermore, the same pieces can be used for the high-side and low-side auxiliary terminals. Thereby, the production costs, due to economics of scale and reduced tooling costs, and the risk for faulty assembly is reduced.

In embodiments, the same shape applies to all corresponding high-side and low-side auxiliary terminals in a power module. It is also possible that the same shape only applies to one or several corresponding high-side and low-side auxiliary terminals but not to all corresponding auxiliary terminals.

At least two of the auxiliary terminals of the same side may be mechanically joined together to form a unit, e.g., a unit of gate and auxiliary emitter or source terminals. The auxiliary terminals may be joined together before connecting the auxiliary terminals to the substrate. Thereby, the manufacturing process can be simplified. In that case, the units of auxiliary terminals of different sides have the same geometric shape

The auxiliary terminal of the high-side and low-side devices having the same shape may be arranged in the power module with a 180° rotational symmetry. The rotational symmetry may be relative to an axis running perpendicular to main surfaces of the substrates. As an example, the axis may run through a center of the power module.

In embodiments, not only the auxiliary terminals but the substrates or the entire electrical paths of corresponding auxiliary circuits for the high-side switching device and the low-side switching device have the same geometric shapes or mirror-symmetric geometric shapes. In case that the power module comprises more than two substrates, the same geometric shape is for one or more pairs of substrates for high-side and low-side switching devices. The same geometric shape may exist for all pairs of high-side and low-side switching devices.

In case that the high-side switching device and the low-side switching device are located on the same substrate, the substrate has a 180 ° rotational symmetry. The symmetry axis may be located centrally in the substrate. The entire electrical paths may be arranged in the power module with a 180° rotational symmetry. The electrical paths comprise the substrate layout, connectors such as wirebonds and the auxiliary terminals.

For auxiliary terminals having a mirror-symmetric shape, the one or more substrates may have a mirror-symmetry relative to a mirror plane. In case of a single substrate, the mirror plane may run through the substrate, in case of several substrates, the mirror plane may run between the substrates. The entire electrical paths may be arranged in the power module with a mirror symmetry relative to a symmetry plane. The power module may comprise two or more high-side switching devices and two or more low-side switching devices. The switching devices of the same side may be electrically connected in parallel. Each of the auxiliary terminals may comprise at least two internal connection portions for electrical connection to the at least two switching devices of the same side. In this case, the substrates on which switching devices of the same side are located may be separate from each other. Only one internal connection portion may be sufficient if the switching devices of the same side are located on the same substrate.

In case that each of the sides comprises several high-side and several low-side switching devices and/or several substrates, the symmetry may be present only for one pair, for several pairs or for all pairs of switching devices and/or substrates.

According to a further aspect of the present invention, a method of manufacturing a power module is claimed in independent claim 10.

Each of the auxiliary terminals comprises at least one internal connection portion being connected to at least one of the substrates and at least one external connection portion for connection to an external connector, and an intermediate portion connecting the internal and external portion. The intermediate portion comprises at least one horizontal section running in a horizontal direction and/or at least one oblique section running both in horizontal and vertical direction relative to a main surface of the substrates, wherein the internal connection portion has a different vertical and horizontal position relative to a main surface of the substrates than the external connection portion. The method of claim 10 results in the power module of claim 1. The method and the power module may have the same electrical and functional characteristics.

In the method, several auxiliary terminals may be provided and mechanically connected to each other before being connected to the substrate. Both for the high-side switching device and for the low-side switching device units of mechanically connected auxiliary terminals may be provided. As an example, the terminals may be connected to each other by an insulating glue or may be embedded into resin material forming a kind of terminal block, for example. Thereby, the production process is further simplified.

The present disclosure comprises several aspects and embodiments. Every feature described with respect to one of the aspects and embodiments is also disclosed herein with respect to the other aspects and embodiments, even if the respective feature is not explicitly mentioned in this context and if the respective feature is compatible with the other embodiment.

Further features, refinements and expediencies become apparent from the following description of the exemplary embodiments in connection with the figures. In the figures, elements of the same structure and/or functionality may be referenced by the same reference signs. It is to be understood that the embodiments shown in the figures are illustrative representations and are not necessarily drawn to scale.
Figure 1 is a top view of a half-bridge power module according to an embodiment,
Figure 2A is a perspective view of two auxiliary terminals of the high-side switching device of Figure 1,
Figure 2B is a perspective view of two auxiliary terminals of the low-side switching device of Figure 1,
Figure 3A and 3B are perspective views of two auxiliary terminals of a high-side switching device and a low-side switching device of a power module according to an example not in accordance with the claims,
Figure 4 is a top view of a power module according to an example not in accordance with the claims,
Figure 5 is a top view of a power module according to a further embodiment,
Figure 6A is a perspective view of two auxiliary terminals of the high-side switching device of Figure 5,
Figure 6B is a perspective view of two auxiliary terminals of the low-side switching device of Figure 5,
Figure 7 is a perspective view of two auxiliary terminals comprising further connection parts.

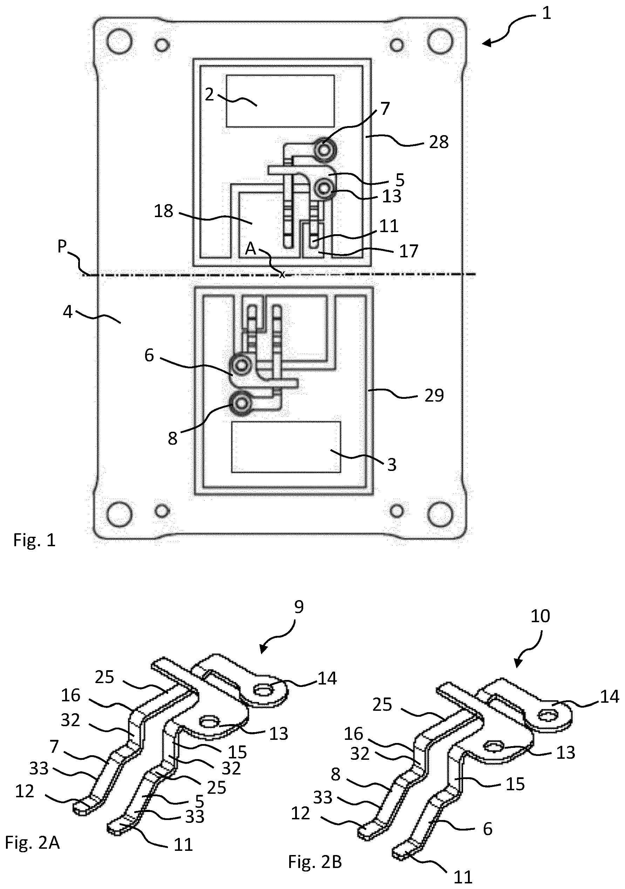

Figure 1 shows a top view of an embodiment of a power module 1. The power module 1 may be used in automotive applications, for example. The power module 1 is a half-bridge semiconductor power module comprising at least one high-side switching device 2 and at least one low-side switching device 3.

A half-bridge is an electric circuit comprising two switching devices connected in series between a DC+ (positive) and DC-(negative) terminal, wherein an AC terminal is connected to emitter or source of the high-side switching device and to the collector or drain of the low-side switching device. The switching device connected to the DC+ terminal is denoted as high-side (HS) switching device, the switching device connected to the DC- terminal is denoted as the low-side (LS) switching device.

The position of the switching devices 2, 3 is indicated schematically in Figure 1. The switching devices 2, 3 are located on separate substrates 28, 29 which are located on a baseplate 4. Each of the substrates 28, 29 provides a pattern of metallizations 17, 18 for electrical connection to the switching devices 2, 3 and to terminals. It is also possible that the switching devices 2, 3 are located not on separate substrates 28, 29 but on the same substrate.

The substrates 28, 29 may be direct bonded copper substrates or insulating metal substrates, for example. The baseplate 4 may be of an insulating or a non-insulating material. As an example, the baseplate may comprise or consist of a metal like copper or a composite material like AlSiC.

The switching devices 2, 3 may be in the form of IGBTs, MOSFETS, JFETs, HEMTs or MISFETS, for example. The power module 1 may comprise several low-side and several high-side switching devices which may be arranged in the form of rows on the baseplate 4, for example.

The power module 1 comprises several auxiliary terminals 5, 6, 7, 8 for controlling and/or monitoring the switching devices 2, 3. As an example, a first HS auxiliary terminal 5 and a first LS auxiliary terminal 6 are electrically connected to a gate of the respective switching device 2, 3. A second HS auxiliary terminal 7 and a second LS auxiliary terminal 8 may be connected to a source or emitter of the respective switching device 2, 3.

The power module 1 further comprises power terminals for supplying power to the respective switching device 2, 3. The power terminals may comprise a DC+, a DC- and an AC terminal (not shown here), in accordance with a described half-bridge setup. The current flowing through the auxiliary terminals and in the auxiliary paths is much lower than the current in the power path. As an example, a current in the auxiliary paths may be below 1 Ampere. The current flowing through the power terminals may be several hundred Ampere, for example.

The first HS auxiliary terminal 5 and the first LS auxiliary terminal 6 may be terminals for a gate of the high-side switching device 2 and the low-side switching device 3, respectively. The second HS auxiliary terminal 7 and the second LS auxiliary terminal 8 may be auxiliary terminals for an emitter of the HS switching device 2 and the LS switching device 3, respectively. The first HS and first LS auxiliary terminals 5, 6 are corresponding terminals, having the same function and connectivity for the HS and LS switching devices 2, 3. Also the second HS and second LS auxiliary terminals 7, 8 are corresponding terminals.

Figure 2A shows the two auxiliary terminals 5, 7 of the HS switching device 2 of Figure 1 and Figure 2B shows the two auxiliary terminals 6, 8 of the LS switching device 3 of Figure 1 in perspective views. The relative position and orientation of the HS terminals 5, 7 to each other in an assembly 9 is the same as in Figure 1. The same applies for the assembly 10 of LS terminals 6, 8 shown in Figure 2B.

As can be seen from a comparison of Figures 2A and 2B, the first HS auxiliary terminal 5 has the same shape as the first LS auxiliary terminal 6. Also the second HS auxiliary terminal 7 has the same shape as the second LS auxiliary terminal 8. Overall, corresponding terminals have the same shape. In the shown embodiment, also the assembly 9 of HS terminals 5, 7 has the same shape as the assembly 10 of LS terminals 6, 8. It is possible that not all HS auxiliary terminals have the same shape as corresponding LS auxiliary terminals.

Thereby, the electrical pathways of corresponding HS and LS auxiliary circuits are made more similar to each other. In an ideal case, the auxiliary circuits have identical shapes. The electrical pathway of auxiliary circuits, such as the gate connection path or the auxiliary emitter path, may comprise or consist of the respective auxiliary terminal, electrical paths on the substrates 28, 29 and wirebond connections, for example.

It is also possible that the auxiliary terminals of the same side are mechanically joined to each other to form a common terminal unit. As an example, the HS auxiliary terminals 5, 7 may be joined together before being connected to the substrate 28. The same can be done for the LS auxiliary terminals 6, 8. As an example, the auxiliary terminals of one side may be mechanically connected to each other by an electrically insulating glue or embedded into resin material, forming a kind of terminal block.

Each of the auxiliary terminals 5, 6, 7, 8 comprises an internal connection portion 11, 12 for connection to the respective substrate 28, 29. The internal connection portions 11, 12 may be formed as feet, for example. The internal connection portions 11, 12 may be directly connected to a metallization 17, 18 (see Figure 1) of the respective substrate 28, 29. The connection is made by soldering, gluing or welding, such as ultrasonic or laser welding, or any other applicable soldering, gluing or welding method. The metallizations 17, 18 may be directly connected to one of the switching devices 2, 3 or may be connected by further connectors such as wirebonds and/or further metallizations to the switching devices 2, 3.

Each of the auxiliary terminals 5, 6, 7, 8 comprises an external connection portion 13, 14 for connection to an external connector. The external connection portion 13, 14 may be a flat portion and may comprise a screw hole for a screw-thread connection to the external connector. The external connection portion 13, 14 may be a plate-shaped portion or lash.

The external connector may be in the form of a busbar, for example. The external connector may be connected to the external connection portion 13, 14 by a bolt, for example. Also other connection types like tubular connectors, auxiliary nuts, pin terminals or press-fit pins or other designs are possible. It is also possible that one or both of the auxiliary terminals 5, 7 has more than one external connection portion 13, 14.

The external connection portions 13, 14 are connected to the internal connection portions 11, 12 by intermediate portions 15, 16. The intermediate portions 15, 16 run from the respective internal connection portion 11, 12 vertically and horizontally relative to main surface of the substrates 28, 29 and/or the baseplate 4 such that the respective external connection portions 13, 14 are arranged at a distance from the associated internal connection portions 11, 12 both in a horizontal and vertical direction. In the figure, a main surface of the substrates 28, 28 and/or the baseplate 4 is parallel to the figure plane.

Thus, the internal connection portions 11, 12 have a different vertical and horizontal position relative to a main surface of the substrates 28, 29 and/or the baseplate 4 than the external connection portion 13, 14 of the same auxiliary terminal 5, 6, 7, 8. Accordingly, the internal connection portions 11, 12 are located on a different height and a different lateral position than the associated external connection portion 13, 14. The auxiliary terminals 5, 6, 7, 8 have three-dimensional structures and do not merely run upwards like a pin-shaped terminal. In further embodiments which do not form part of the claimed invention, the internal connection portions 11, 12 may have a different height position but the same lateral position as the associated external connection portion 13, 14. In this case, one or more horizontal and/or oblique sections may form a U-shape for stress-relief, for example.

Each of the intermediate portions 15, 16 have one or more kinks or bends. Furthermore, each of the intermediate portions 15, 16 has at least one horizontal section 25 running only horizontally and/or at least one oblique section 33 running oblique to a main surface of the substrates 28, 29. The main surface defines an x-y plane and the vertical direction defines a z-axis. A horizontal section runs parallel to the x-y plane and the oblique section runs neither parallel nor perpendicular to the x-y plane. In particular, oblique means that an angle between the direction of the oblique section 33 and a main surface of the substrates 28, 29 is larger than 0 ° and smaller than 90 °. The angle may be larger than 10 ° and smaller than 80 °, for example. The intermediate portions 15, 16 also have one or more vertical sections 32, i.e. portions running in the z-direction.

Each of the auxiliary terminals 5, 6, 7, 8 may be formed from a single piece. It is also possible that one or more of the auxiliary terminals 5, 6, 7, 8 may be formed from multiple pieces. The auxiliary terminals 5, 6, 7, 8 can be made of thin metal sheets such as copper or copper alloy sheets. The sheets may be stamped, cut-out or etched from a larger plate and bend into a three-dimensional geometry. The auxiliary terminals 5, 6, 7, 8 may be formed as clips. As an example, the auxiliary terminals 5, 6, 7, 8 may be in the form of busbars.

In the embodiment shown in Figure 1, the entire pathway of corresponding HS and LS auxiliary paths, consisting of a respective auxiliary terminal, an electrical path on the substrate 28, 29 and wirebond connections, may have the same shape. In this case, only some of or all corresponding pathways of HS and LS auxiliary paths may have the same shape.

Furthermore, in the shown embodiment, the HS auxiliary terminals 5, 7 are arranged with a 180 ° rotational symmetry to the LS auxiliary terminals 6, 8. In particular, the HS auxiliary terminals 5, 7 coincide with the LS auxiliary terminals 6, 8 when rotated by 180 ° about an axis A (see Figure 1). The axis A is perpendicular to a main surface of the power module 1. It is possible that the 180° rotational symmetry is present for only one of the HS auxiliary terminal or for the entire assembly 9 of several HS auxiliary terminals 5, 7. As can be seen, also the substrates 28, 29 have a 180° rotational symmetry. In the shown embodiment, the entire HS auxiliary pathways have a 180° rotational symmetry to the entire LS auxiliary pathways.

In the embodiment shown in Figure 1, all HS and LS auxiliary pathways have a 180 ° rotational symmetry when rotated about the same axis A. Accordingly, the substrate designs for the HS and LS devices 2, 3 are identical. Consequently, identical complete electrical paths for the auxiliary circuit of HS and LS devices 2, 3 are realized.

The auxiliary terminals 6, 8 may have recesses, holes or extensions used to hold the terminals in the correct position during a molding process. For auxiliary terminals 6, 8 having an identical shape, also these structures are identical, enabling a reduction of costs.

Thereby, a very balanced electro-magnetic coupling behavior of LS and high-side devices 2, 3 is achieved, resulting in homogeneous and identical, or mostly identical, switching behavior of HS and LS devices 2, 3.

Furthermore, the number of different terminal parts and/or substrate layouts is reduced, resulting in a significant cost reduction due to economics of scale and reduced tooling costs. It is possible to use an identical substrate layout for all switching devices 2, 3. In the production of the power module 1, the logistic is simplified and occurrence of wrong assembly is reduced.

It is also possible that some or all of the HS auxiliary terminals 5, 7 may have the same shape. Also for the LS, some or all of the auxiliary terminals 6, 8 may have the same shape.

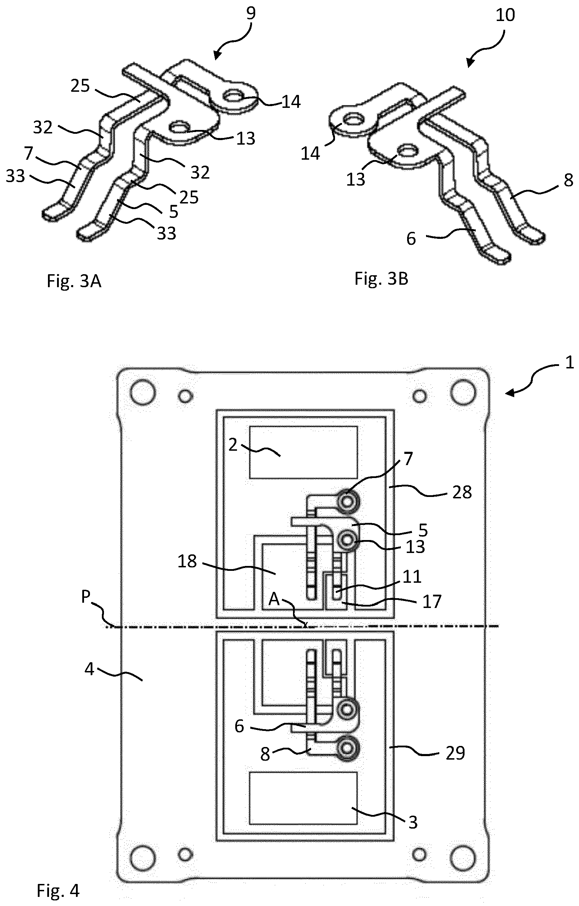

Figures 3A and 3B show a further embodiment of HS and LS auxiliary terminals 5, 6, 7, 8 which does not form part of the claimed invention but is useful for the understanding of the invention. In contrast to the embodiment of Figures 2A and 2B, the shape of the LS auxiliary terminals 6, 8 has a mirror symmetry to the shape of the HS auxiliary terminals 5, 7. In particular, the entire assembly 10 of the LS auxiliary terminals 6, 8 is mirror symmetric to the assembly 9 of the HS auxiliary terminals 5, 7.

Figure 4 shows a power module 1, comprising mirror-symmetric auxiliary terminals 5, 6, 7, 8 as shown in Figures 3A und 3B. The HS auxiliary terminals 5, 7 are arranged with a mirror symmetry relative to a symmetry plane P being perpendicular to a main surface of the power module 1. Also here, it is possible that the mirror symmetry is present for only one of the corresponding auxiliary terminals, or for corresponding assemblies 9, 10. In the shown embodiment, also the substrates 28, 29 have a mirror symmetry relative to the symmetry plane P. In case that only one substrate is used for the entire setup, the substrate would have a mirror-symmetrical shape relative to a symmetry plane within the substrate.

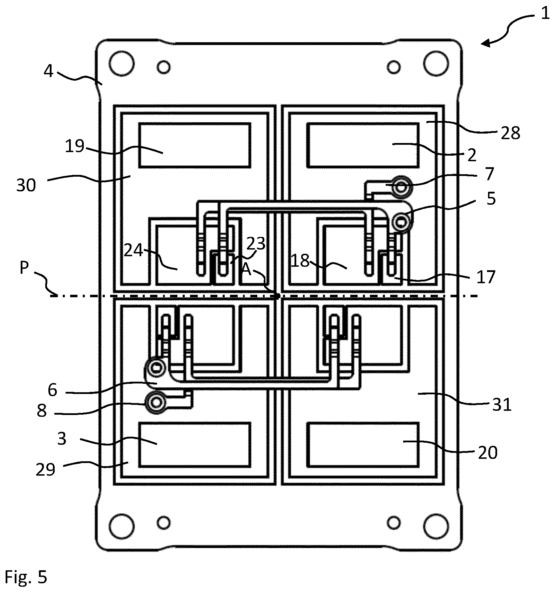

Figure 5 shows a further embodiment of a power module 1. The power module 1 comprises two HS switching devices 2, 19 located on separate substrates 28, 30 and two LS switching devices 3, 20 located on separate substrates 29, 31. The HS switching devices 2, 19 are connected in parallel to each other and the LS switching devices 3, 20 are connected in parallel to each other.

The HS switching devices 2, 19 are electrically connected to a common first HS auxiliary terminal 5 which may be connected to a gate of the HS switching devices 2, 19 and a common second HS auxiliary terminal 7 which may be connected to an emitter or source of the HS switching devices 2, 19. The LS switching devices 3, 20 are electrically connected to a common first LS auxiliary terminal 6 which may be connected to a gate of the HS switching devices 2, 19 and a common second LS auxiliary terminal 8 which may be connected to an emitter or source of the LS switching devices 3, 20. In the shown embodiment, each of the HS auxiliary terminals 5, 7 interconnects two substrates 28, 30 and each of the LS auxiliary terminals interconnects two substrates 29, 31.

As for the power module 1 of Figure 1, the power module 1 has a rotational symmetry of 180 ° about an axis A perpendicular to a main surface of the baseplate 4. The rotational symmetry is present for the entire electrical pathways of the auxiliary circuits comprising metallization patterns, wirebonds and auxiliary terminals 5, 6, 7, 8. Also the position of the switching devices 2, 3, 19, 20 has this symmetry. In a further embodiment which does not form part of the claimed invention, it is possible that instead of a rotational symmetry, a mirror symmetry relative to a symmetry plane P perpendicular to the main surface of the baseplate 4 exists. The functionality and structure of the components is corresponding to the embodiment of Figure 1.

In a further embodiment, not all substrates have the same shape or a mirror-symmetric shape. As examples, it is also possible that only diagonal pairs, in the case of rotational symmetry, or vertical pairs, in case of mirror symmetry, which does not form part of the claimed invention, have the same or a mirror-symmetric shape.

In the case that the power module 1 has only one large substrate instead of separate substrates 28, 29, 30, 31, the substrate layout and the arrangement of switching devices 2, 3, 19, 20 has a 180 ° rotational symmetry.

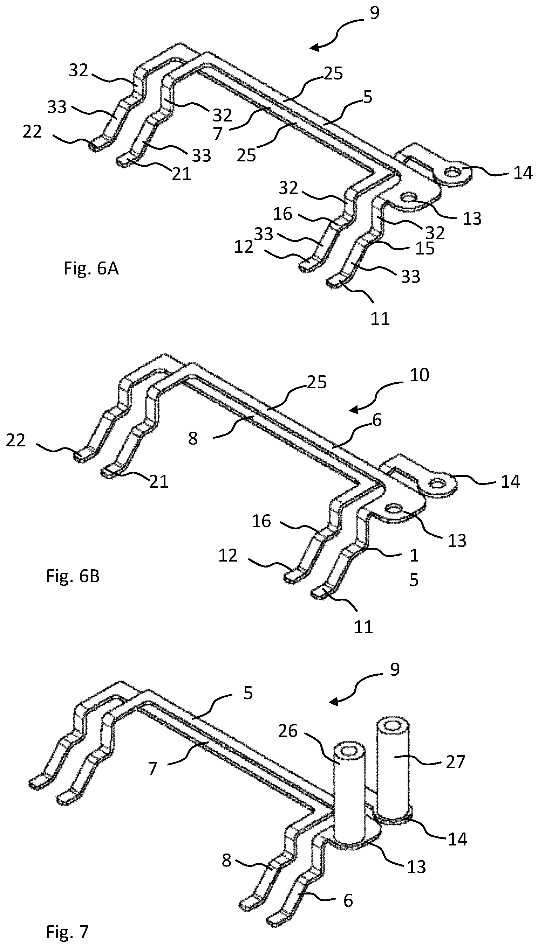

Figure 6A shows an assembly 9 of first and second HS auxiliary terminals 5, 7 and Figure 6B shows an assembly 10 the first and second LS auxiliary terminals 6, 8 of the embodiment of Figure 5 in a perspective view.

As for the auxiliary terminals 5, 6, 7, 8 in Figures 2A and 2B, the auxiliary terminals 5, 6, 7, 8 of the same side may be mechanically connected to form a unit. It is also possible that the auxiliary terminals of the same side are not mechanically connected to each other.

Each of the auxiliary terminals 5, 6, 7, 8 has two internal connection portions 11, 12, 21, 22, each in the shape of a foot. The internal connection portions 11, 12, 21, 22 are connected to metallizations 17, 18, 23, 24 of the substrates 28, 29, 30, 31. The HS auxiliary terminals 5, 7 are each connected to both HS switching devices 2, 19 and the LS auxiliary terminals 6, 8 are each connected to both LS switching devices 3, 20.

The internal connection portions 11, 21 of the first HS auxiliary terminal 5 are connected to each other and to an external connection portion 13 by an intermediate portion 15. The intermediate portions 15, 16 comprise sections running horizontally and vertically.

Each of the intermediate portions 15 includes a horizontal section 25 in the shape of a bar. The horizontal section 25 runs parallel to a main surface of the baseplate 4. Correspondingly, the internal connection portions 12, 20 of the second HS auxiliary terminal 7 are connected to each other and to an external connection portion 14 by an intermediate portion 16 including the horizontal section 25. Furthermore, each of the intermediate portions 15, 16 comprises one or more oblique sections 33 running oblique to a main surface of the substrates 28, 29. The intermediate portions 15, 16 also have one or more vertical sections 32. As can be seen from a comparison of Figures 6A and 6B, the first HS auxiliary terminal 5 has the same geometric shape as the first LS auxiliary terminal 6 and the second HS auxiliary terminal 7 has the same geometric shape as the second LS auxiliary terminal 8. Also the assembly 9 of HS auxiliary terminals 5, 7 has the same geometric shape as the assembly 10 of LS auxiliary terminals 6, 8. In embodiments, the power module 1 may not have an overall symmetry but only the same geometric shape for corresponding HS and LS auxiliary terminals. It is also possible that only one pair of corresponding HS and LS auxiliary terminals have the same shape.

Figure 7 shows the assembly 9 of HS auxiliary terminals 5, 7 of Figure 6A comprising further connection parts 26, 27 for connection to external connectors. The further connection parts 26, 27 are pin-shaped and screw-fixed to the external connection portions 13, 14. Thus, each of the auxiliary terminals 5, 6 has multiple parts.

The LS auxiliary terminals also have further connection parts and have the same geometric shape, according to the claimed invention, or a mirror-symmetric shape, in accordance with embodiments which do not form part of the claimed invention.

The further connection parts 26, 27 are configured to be connected to external connectors. The external connectors may be screw fixed to the further connection parts 26, 27 and may be electrically connected to monitoring and/or control electronics. Other types of external connectors or connection methods are feasible.

### Reference Signs

- 1: power module
- 2: high-side (HS) switching device
- 3: low-side (HS) switching device
- 4: baseplate
- 5: first high-side (HS) auxiliary terminal
- 6: first low-side (LS) auxiliary terminal
- 7: second high-side (HS) auxiliary terminal
- 8: second low-side (LS) auxiliary terminal
- 9, 10: assembly
- 11, 12: internal connection portion
- 13, 14: external connection portion
- 15, 16: intermediate portion
- 17, 18: metallization
- 19: further high-side (HS) switching device
- 20: further low-side (LS) switching device
- 21, 22: further internal connection portion
- 23, 24: further metallization
- 25: horizontal section
- 26, 27: further connector
- 28: high-side (HS) substrate
- 29: low-side (LS) substrate
- 30: further high-side (HS) substrate
- 31: further low-side (LS) substrate
- 32: vertical section
- 33: oblique section

- A: axis
- P: plane

## Claims

1. A half-bridge power module (1),
comprising one substrate or at least one pair of substrates (28, 29, 30, 31), one or more high-side switching device (2, 19) and one or more low-side switching device (3, 20) located on the one substrate or respective ones of the pair of substrates (28, 29, 30, 31),
comprising at least one high-side auxiliary terminal (5, 7) and at least one low-side auxiliary terminal (6, 8) for controlling and/or monitoring at least one of the respective switching device (2, 3, 19, 20),
wherein each of the high-side auxiliary terminal (5, 7) and the low-side auxiliary terminal (6, 8) comprises at least one internal connection portion (11, 12, 21, 22) being connected by soldering, gluing or welding to the one substrate or the pair of substrates (28, 29, 30, 31), at least one external connection portion (13, 14) for connection to the outside, and at least one intermediate portion (15) connecting the internal connection portion (11, 12, 21, 22) and the external connection portion (13, 14),
wherein the intermediate portion (15) comprises at least one horizontal section (25) running in a horizontal direction, wherein the horizontal direction is parallel to a main surface of the one substrate or pair of substrates, and/or at least one oblique section running obliquely to a main surface of the one substrate or pair of substrates (28, 29, 30, 31),wherein the internal connection portion (11, 12, 21, 22) has a different vertical and horizontal position relative to a main surface than the external connection portion (13, 14) of the same auxiliary terminal (5, 6, 7, 8),
wherein at least one high-side auxiliary terminal (5, 7) and at least one low-side auxiliary terminal (6, 8) have the same geometric shapes,
wherein metallization patterns of the pair of substrates (28, 29, 30, 31) have the same geometric shapes and a 180° rotational symmetry relative to a symmetry axis (A) perpendicular to the main surface of the substrates or metallization patterns of the one substrate have a 180° rotational symmetry relative to a symmetry axis (A) perpendicular to the main surface of the one substrate.

2. The half-bridge power module (1) of claim 1,
wherein the auxiliary terminals (5, 6, 7, 8) are in the form of bend metal sheets.

3. The half-bridge power module (1) of any of the preceding claims, wherein each of the high-side auxiliary terminal (5, 7) and the low-side auxiliary terminal (6, 8) comprises an intermediate portion (15, 16) connecting the at least one internal connection portion (11, 12) and the external connection portion (13, 14), wherein the intermediate portion (15, 16) comprises at least one horizontal section (25) in the shape of a bar.

4. The half-bridge power module (1) of any of the preceding claims, wherein at least one high-side switching device (2, 19) and at least one low-side switching device (3, 20) comprises a gate, wherein at least one high-side auxiliary terminal (5, 7) and at least one low-side auxiliary terminal (6, 8) having the same geometric shapes are electrically connected to the respective gate.

5. The half-bridge power module (1) of any of the preceding claims, wherein at least one high-side switching device (2, 19) and at least one low-side switching device (3, 20) comprises an emitter or source, wherein at least one high-side auxiliary terminal (5, 7) and at least one low-side auxiliary terminal (6, 8) having the same geometric shapes are electrically connected to the respective emitter or source.

6. The half-bridge power module (1) of any of the preceding claims, wherein at least one high-side auxiliary terminal (2, 19) and at least one low-side auxiliary terminal (3, 20) have the same shapes and are arranged with a 180° rotational symmetry relative to a symmetry axis (A).

7. The half-bridge power module of any of the preceding claims, comprising at least two auxiliary terminals (5, 6, 7, 8) of the same side, which have the same geometric shapes.

8. The half-brige power module of any of the preceding claims,
comprising at least two auxiliary terminals (5, 6, 7, 8) of the same side being mechanically joined to each other.

9. The half-bridge power module of any of the preceding claims, comprising at least two high-side switching devices (2, 19) and at least two low-side switching devices (3, 20), wherein each of the auxiliary terminals (5, 6, 7, 8) having the same geometric shapes comprises at least two internal connection portions (11, 12, 21, 22) for electrical connection to the at least two switching devices (2, 3, 19, 20) of the same side.

10. Method of manufacturing a half-bridge power module (1), comprising the steps of:
providing one substrate or at least one pair of substrates (28, 29, 30, 31), one or more high-side switching devices (2, 19) and one or more low-side switching device (3, 20), wherein the high-side switching device and the low-side switching device are arranged on the one substrate or respective ones of the pair of substrates (28, 29, 30, 31), providing at least two auxiliary terminals (5, 6, 7, 8) having the same geometric shapes,
connecting the auxiliary terminals (5, 6, 7, 8) to the one or more substrates (28, 29, 30, 31) such that one of the auxiliary terminals (5, 6, 7, 8) is electrically connected to the high-side switching device (2, 19) and another one of the auxiliary terminals (5, 6, 7, 8) is electrically connected to the low-side switching device (3, 20), wherein each of the auxiliary terminals (5, 6, 7, 8) comprises at least one internal connection portion (11, 12, 21, 22) being connected by soldering, gluing or welding to the one substrate or the pair of substrates (28, 29, 30, 31) and at least one external connection portion (13, 14) for connection to the outside, and at least one intermediate portion (15) connecting the internal connection portion (11, 12, 21, 22) and the external connection portion (13, 14),
wherein the intermediate portion (15) comprises at least one horizontal section (25) running in a horizontal direction,
wherein the horizontal direction is parallel to a main surface of the one substrate or pair of substrates, and/or at least one oblique section running obliquely relative to a main surface of the one substrate or pair of substrates (28, 29, 30, 31),
wherein the internal connection portion (11, 12, 21, 22) has a different vertical and horizontal position relative to a main surface than the external connection portion (13, 14) of the same auxiliary terminal (5, 6, 7, 8),
wherein metallization patterns of the pair of substrates (28, 29, 30, 31) have the same geometric shapes and a 180° rotational symmetry relative to a symmetry axis perpendicular to the main surface of the substrates or metallization patterns of the one substrate have a 180° rotational symmetry relative to a symmetry axis (A) perpendicular to the main surface of the one substrate.

11. The method of claim 10,
wherein more than two auxiliary terminals (5, 6, 7, 8) are provided and at least two of the auxiliary terminals (5, 6, 7, 8) are mechanically connected to each other before being connected to the one substrate or to the pair of substrates (28, 29, 30, 31).

## Patentansprüche

1. Halbbrücken-Leistungsmodul (1),
das ein Substrat oder mindestens ein Substratpaar (28, 29, 30, 31), eine oder mehrere hochseitige Schaltvorrichtungen (2, 19) und eine oder mehrere tiefseitige Schaltvorrichtungen (3, 20), die auf dem einen Substrat oder auf jeweiligen des Substratpaares (28, 29, 30, 31) angeordnet sind, aufweist, das mindestens einen hochseitigen Hilfsanschluss (5, 7) und mindestens einen tiefseitigen Hilfsanschluss (6, 8) zum Steuern und/oder Überwachen von mindestens einer der jeweiligen Schaltvorrichtung (2, 3, 19, 20) aufweist,
wobei der hochseitige Hilfsanschluss (5, 7) und der tiefseitige Hilfsanschluss (6, 8) jeweils mindestens einen internen Verbindungsabschnitt (11, 12, 21, 22), der durch Löten, Kleben oder Schweißen mit dem einen Substrat oder dem Substratpaar (28, 29, 30, 31) verbunden ist, mindestens einen externen Verbindungsabschnitt (13, 14) zur Verbindung nach außen und mindestens einen Zwischenabschnitt (15), der den internen Verbindungsabschnitt (11, 12, 21, 22) und den externen Verbindungsabschnitt (13, 14) verbindet, aufweisen,
wobei der Zwischenabschnitt (15) mindestens einen horizontalen Abschnitt (25), der in einer horizontalen Richtung verläuft, wobei die horizontale Richtung zu einer Hauptfläche des einen Substrats oder des Substratpaares parallel ist, und/oder mindestens einen schrägen Abschnitt, der schräg zu einer Hauptfläche des einen Substrats oder des Substratpaares (28, 29, 30, 31) verläuft, aufweist, wobei der interne Verbindungsabschnitt (11, 12, 21, 22) eine andere vertikale und horizontale Position in Bezug auf eine Hauptfläche als der externe Verbindungsabschnitt (13, 14) desselben Hilfsanschlusses (5, 6, 7, 8) aufweist,
wobei mindestens ein hochseitiger Hilfsanschluss (5, 7) und mindestens ein tiefseitiger Hilfsanschluss (6, 8) dieselben geometrischen Formen aufweisen,
wobei Metallisierungsstrukturen des Substratpaares (28, 29, 30, 31) dieselben geometrischen Formen und eine Rotationssymmetrie von 180° in Bezug auf eine Symmetrieachse (A), die zur Hauptfläche der Substrate senkrecht ist, aufweisen oder Metallisierungsstrukturen des einen Substrats eine Rotationssymmetrie von 180° in Bezug auf eine Symmetrieachse (A), die zur Hauptfläche des einen Substrats senkrecht ist, aufweisen.

2. Halbbrücken-Leistungsmodul (1) nach Anspruch 1,
wobei die Hilfsanschlüsse (5, 6, 7, 8) die Form gebogener Metallbleche aufweisen.

3. Halbbrücken-Leistungsmodul (1) nach einem der vorhergehenden Ansprüche, wobei der hochseitige Hilfsanschluss (5, 7) und der tiefseitige Hilfsanschluss (6, 8) jeweils einen Zwischenabschnitt (15, 16) aufweisen, der den mindestens einen internen Verbindungsabschnitt (11, 12) und den externen Verbindungsabschnitt (13, 14) verbindet, wobei der Zwischenabschnitt (15, 16) mindestens einen horizontalen Abschnitt (25) in der Form einer Schiene aufweist.

4. Halbbrücken-Leistungsmodul (1) nach einem der vorhergehenden Ansprüche, wobei mindestens eine hochseitige Schaltvorrichtung (2, 19) und mindestens eine tiefseitige Schaltvorrichtung (3, 20) ein Gate aufweisen, wobei mindestens ein hochseitiger Hilfsanschluss (5, 7) und mindestens ein tiefseitiger Hilfsanschluss (6, 8), die dieselben geometrischen Formen aufweisen, mit dem jeweiligen Gate elektrisch verbunden sind.

5. Halbbrücken-Leistungsmodul (1) nach einem der vorhergehenden Ansprüche, wobei mindestens eine hochseitige Schaltvorrichtung (2, 19) und mindestens eine tiefseitige Schaltvorrichtung (3, 20) einen Emitter oder eine Source aufweisen, wobei mindestens ein hochseitiger Hilfsanschluss (5, 7) und mindestens ein tiefseitiger Hilfsanschluss (6, 8), die dieselben geometrischen Formen aufweisen, mit dem jeweiligen Emitter oder der jeweiligen Source elektrisch verbunden sind.

6. Halbbrücken-Leistungsmodul (1) nach einem der vorhergehenden Ansprüche, wobei mindestens ein hochseitiger Hilfsanschluss (2, 19) und mindestens ein tiefseitiger Hilfsanschluss (3, 20) dieselben Formen aufweisen und mit einer Rotationssymmetrie von 180° in Bezug auf eine Symmetrieachse (A) angeordnet sind.

7. Halbbrücken-Leistungsmodul nach einem der vorhergehenden Ansprüche, das mindestens zwei Hilfsanschlüsse (5, 6, 7, 8) derselben Seite, die dieselben geometrischen Formen aufweisen, aufweist.

8. Halbbrücken-Leistungsmodul nach einem der vorhergehenden Ansprüche,
das mindestens zwei Hilfsanschlüsse (5, 6, 7, 8) derselben Seite, die mechanisch miteinander verbunden sind, aufweist.

9. Halbbrücken-Leistungsmodul nach einem der vorhergehenden Ansprüche, das mindestens zwei hochseitige Schaltvorrichtungen (2, 19) und mindestens zwei tiefseitige Schaltvorrichtungen (3, 20) aufweist, wobei die Hilfsanschlüsse (5, 6, 7, 8), die dieselben geometrischen Formen aufweisen, jeweils mindestens zwei interne Verbindungsabschnitte (11, 12, 21, 22) zur elektrischen Verbindung mit den mindestens zwei Schaltvorrichtungen (2, 3, 19, 20) derselben Seite aufweisen.

10. Verfahren zum Herstellen eines Halbbrücken-Leistungsmoduls (1), das die folgenden Schritte aufweist:
Bereitstellen eines Substrats oder mindestens eines Substratpaares (28, 29, 30, 31), einer oder mehrerer hochseitiger Schaltvorrichtungen (2, 19) und einer oder mehrerer tiefseitiger Schaltvorrichtungen (3, 20), wobei die hochseitige Schaltvorrichtung und die tiefseitige Schaltvorrichtung auf dem einen Substrat oder auf jeweiligen des Substratpaares (28, 29, 30, 31) angeordnet sind, Bereitstellen mindestens zweier Hilfsanschlüsse (5, 6, 7, 8), die dieselben geometrischen Formen aufweisen,
Verbinden der Hilfsanschlüsse (5, 6, 7, 8) mit dem einen oder den mehreren Substraten (28, 29, 30, 31), derart, dass einer der Hilfsanschlüsse (5, 6, 7, 8) mit der hochseitigen Schaltvorrichtung (2, 19) elektrisch verbunden ist und ein weiterer der Hilfsanschlüsse (5, 6, 7, 8) mit der tiefseitigen Schaltvorrichtung (3, 20) elektrisch verbunden ist, wobei die Hilfsanschlüsse (5, 6, 7, 8) jeweils mindestens einen internen Verbindungsabschnitt (11, 12, 21, 22), der durch Löten, Kleben oder Schweißen mit dem einen Substrat oder dem Substratpaar (28, 29, 30, 31) verbunden ist, und mindestens einen externen Verbindungsabschnitt (13, 14) zur Verbindung nach außen und mindestens einen Zwischenabschnitt (15), der den internen Verbindungsabschnitt (11, 12, 21, 22) und den externen Verbindungsabschnitt (13, 14) verbindet, aufweisen,
wobei der Zwischenabschnitt (15) mindestens einen horizontalen Abschnitt (25), der in einer horizontalen Richtung verläuft, wobei die horizontale Richtung zu einer Hauptfläche des einen Substrats oder des Substratpaares parallel ist, und/oder mindestens einen schrägen Abschnitt, der in Bezug auf eine Hauptfläche des einen Substrats oder des Substratpaares (28, 29, 30, 31) schräg verläuft, aufweist,
wobei der interne Verbindungsabschnitt (11, 12, 21, 22) eine andere vertikale und horizontale Position in Bezug auf eine Hauptfläche als der externe Verbindungsabschnitt (13, 14) desselben Hilfsanschlusses (5, 6, 7, 8) aufweist,
wobei Metallisierungsstrukturen des Substratpaares (28, 29, 30, 31) dieselben geometrischen Formen und eine Rotationssymmetrie von 180° in Bezug auf eine Symmetrieachse (A), die zur Hauptfläche der Substrate senkrecht ist, aufweisen oder Metallisierungsstrukturen des einen Substrats eine Rotationssymmetrie von 180° in Bezug auf eine Symmetrieachse (A), die zur Hauptfläche des einen Substrats senkrecht ist, aufweisen.

11. Verfahren nach Anspruch 10,
wobei mehr als zwei Hilfsanschlüsse (5, 6, 7, 8) vorgesehen sind und mindestens zwei der Hilfsanschlüsse (5, 6, 7, 8) mechanisch miteinander verbunden werden, bevor sie mit dem einen Substrat oder dem Substratpaar (28, 29, 30, 31) verbunden werden.

## Revendications

1. Module de puissance en demi-pont (1),
comprenant un substrat ou au moins une paire de substrats (28, 29, 30, 31), un ou plusieurs dispositifs de commutation côté haut (2, 19) et un ou plusieurs dispositifs de commutation côté bas (3, 20) situés sur le substrat ou des substrats respectifs de la paire de substrats (28, 29, 30, 31), comprenant au moins une borne auxiliaire côté haut (5, 7) et au moins une borne auxiliaire côté bas (6, 8) pour commander et/ou surveiller au moins l'un du dispositif de commutation respectif (2, 3, 19, 20),
chaque borne auxiliaire parmi la borne auxiliaire côté haut (5, 7) et la borne auxiliaire côté bas (6, 8) comprenant au moins une portion de connexion interne (11, 12, 21, 22) étant connectée par brasage, collage ou soudage au substrat ou à la paire de substrats (28, 29, 30, 31), au moins une portion de connexion externe (13, 14) pour connexion à l'extérieur, et au moins une portion intermédiaire (15) connectant la portion de connexion interne (11, 12, 21, 22) et la portion de connexion externe (13, 14),
la portion intermédiaire (15) comprenant au moins une section horizontale (25) allant dans une direction horizontale,
la direction horizontale étant parallèle à une surface principale du substrat ou de la paire de substrats, et/ou au moins une section oblique allant obliquement par rapport à une surface principale du substrat ou de la paire de substrats (28, 29, 30, 31), la portion de connexion interne (11, 12, 21, 22) ayant une position verticale et horizontale relativement à une surface principale différente de la portion de connexion externe (13, 14) de la même borne auxiliaire (5, 6, 7, 8),
au moins une borne auxiliaire côté haut (5, 7) et au moins une borne auxiliaire côté bas (6, 8) ayant les mêmes formes géométriques,
dans lequel des motifs de métallisation de la paire de substrats (28, 29, 30, 31) ont les mêmes formes géométriques et une symétrie de rotation de 180° relativement à un axe de symétrie (A) perpendiculaire à la surface principale des substrats ou des motifs de métallisation du substrat ont une symétrie de rotation de 180° relativement à un axe de symétrie (A) perpendiculaire à la surface principale du substrat.

2. Module de puissance en demi-pont (1) selon la revendication 1,
dans lequel les bornes auxiliaires (5, 6, 7, 8) sont sous la forme de feuilles métalliques courbées.

3. Module de puissance en demi-pont (1) selon l'une quelconque des revendications précédentes, dans lequel chaque borne auxiliaire parmi la borne auxiliaire côté haut (5, 7) et la borne auxiliaire côté bas (6, 8) comprend une portion intermédiaire (15, 16) connectant l'au moins une portion de connexion interne (11, 12) et la portion de connexion externe (13, 14), la portion intermédiaire (15, 16) comprenant au moins une section horizontale (25) sous la forme d'une barre.

4. Module de puissance en demi-pont (1) selon l'une quelconque des revendications précédentes, dans lequel au moins un dispositif de commutation côté haut (2, 19) et au moins un dispositif de commutation côté bas (3, 20) comprennent une gâchette, dans lequel au moins une borne auxiliaire côté haut (5, 7) et au moins une borne auxiliaire côté bas (6, 8) ayant les mêmes formes géométriques sont électriquement connectées à la gâchette respective.

5. Module de puissance en demi-pont (1) selon l'une quelconque des revendications précédentes, dans lequel au moins un dispositif de commutation côté haut (2, 19) et au moins un dispositif de commutation côté bas (3, 20) comprennent un émetteur ou une source, dans lequel au moins une borne auxiliaire côté haut (5, 7) et au moins une borne auxiliaire côté bas (6, 8) ayant les mêmes formes géométriques sont électriquement connectées à l'émetteur respectif ou la source respective.

6. Module de puissance en demi-pont (1) selon l'une quelconque des revendications précédentes, dans lequel au moins une borne auxiliaire côté haut (2, 19) et au moins une borne auxiliaire côté bas (3, 20) ont les mêmes formes et sont agencées avec une symétrie de rotation de 180° relativement à un axe de symétrie (A).

7. Module de puissance en demi-pont selon l'une quelconque des revendications précédentes, comprenant au moins deux bornes auxiliaires (5, 6, 7, 8) du même côté, qui ont les mêmes formes géométriques.

8. Module de puissance en demi-pont selon l'une quelconque des revendications précédentes,
comprenant au moins deux bornes auxiliaires (5, 6, 7, 8) du même côté qui sont mécaniquement reliées l'une à l'autre.

9. Module de puissance en demi-pont selon l'une quelconque des revendications précédentes, comprenant au moins deux dispositifs de commutation côté haut (2, 19) et au moins deux dispositifs de commutation côté bas (3, 20), dans lequel chacune des bornes auxiliaires (5, 6, 7, 8) ayant les mêmes formes géométriques comprend au moins deux portions de connexion internes (11, 12, 21, 22) pour connexion électrique aux au moins deux dispositifs de commutation (2, 3, 19, 20) du même côté.

10. Procédé de fabrication d'un module de puissance en demi-pont (1), comprenant les étapes consistant à :
fournir un substrat ou au moins une paire de substrats (28, 29, 30, 31), un ou plusieurs dispositifs de commutation côté haut (2, 19) et un ou plusieurs dispositifs de commutation côté bas (3, 20), le dispositif de commutation côté haut et le dispositif de commutation côté bas étant agencés sur le substrat ou des substrats respectifs de la paire de substrats (28, 29, 30, 31),
fournir au moins deux bornes auxiliaires (5, 6, 7, 8) ayant les mêmes formes géométriques,
connecter les bornes auxiliaires (5, 6, 7, 8) aux un ou plusieurs substrats (28, 29, 30, 31) de telle sorte que l'une des bornes auxiliaires (5, 6, 7, 8) soit électriquement connectée au dispositif de commutation côté haut (2, 19) et qu'une autre des bornes auxiliaires (5, 6, 7, 8) soit électriquement connectée au dispositif de commutation côté bas (3, 20), chacune des bornes auxiliaires (5, 6, 7, 8) comprenant au moins une portion de connexion interne (11, 12, 21, 22) étant connectée par brasage, collage ou soudage au substrat ou à la paire de substrats (28, 29, 30, 31) et au moins une portion de connexion externe (13, 14) pour connexion à l'extérieur, et au moins une portion intermédiaire (15) connectant la portion de connexion interne (11, 12, 21, 22) et la portion de connexion externe (13, 14),
la portion intermédiaire (15) comprenant au moins une section horizontale (25) allant dans une direction horizontale,
la direction horizontale étant parallèle à une surface principale du substrat ou de la paire de substrats, et/ou au moins une section oblique allant obliquement relativement à une surface principale du substrat ou de la paire de substrats (28, 29, 30, 31),
la portion de connexion interne (11, 12, 21, 22) ayant une position verticale et horizontale relativement à une surface principale différente de la portion de connexion externe (13, 14) de la même borne auxiliaire (5, 6, 7, 8),
dans lequel des motifs de métallisation de la paire de substrats (28, 29, 30, 31) ont les mêmes formes géométriques et une symétrie de rotation de 180° relativement à un axe de symétrie perpendiculaire à la surface principale des substrats ou des motifs de métallisation du substrat ont une symétrie de rotation de 180° relativement à un axe de symétrie (A) perpendiculaire à la surface principale du substrat.

11. Procédé selon la revendication 10,
dans lequel plus de deux bornes auxiliaires (5, 6, 7, 8) sont fournies et au moins deux des bornes auxiliaires (5, 6, 7, 8) sont mécaniquement connectées l'une à l'autre avant d'être connectées au substrat ou à la paire de substrats (28, 29, 30, 31).
